(19) Europäisches Patentamt
European Patent Office
Office européen des brevets

(11) **EP 1 912 396 A2**

(12) **EUROPEAN PATENT APPLICATION**

(43) Date of publication:
**16.04.2008 Bulletin 2008/16**

(51) Int Cl.:
***H04L 25/03*** (2006.01)

(21) Application number: **07251692.5**

(22) Date of filing: **23.04.2007**

(84) Designated Contracting States:
**AT BE BG CH CY CZ DE DK EE ES FI FR GB GR HU IE IS IT LI LT LU LV MC MT NL PL PT RO SE SI SK TR**
Designated Extension States:
**AL BA HR MK RS**

(30) Priority: **10.10.2006 GB 0620071**

(71) Applicant: **Kabushiki Kaisha Toshiba**
**Minato-ku,**
**Tokyo 105-8001 (JP)**

(72) Inventors:
• **McNamara, Darren Phillip**
  **Bristol BS1 4ND (GB)**
• **Lillie, Andrew George**
  **Bristol BS1 4ND (GB)**
• **Sandell, Magnus Stig Torsten**
  **Bristol BS1 4ND (GB)**

(74) Representative: **Round, Edward Mark**
**Marks & Clerk**
**90 Long Acre**
**London WC2E 9RA (GB)**

(54) **Wireless communications apparatus**

(57) In a lattice-reduction-aided receiver based wireless communications system, soft estimates of transmitted bit values are determined from a received signal by applying lattice reduction to the channel estimate and equalising the received signal in accordance with the reduced basis channel, and determining probabilities of transmitted bits having particular values by selecting a core candidate vector in the reduced basis, determining a set of mapping functions between the core vector in the reduced basis and transmitted symbol vectors from which a set of candidate transmitted symbol vectors can be generated, generating a set of transmitted symbol vectors based on the mapping functions and, on the basis of the received signal determining the probability of each transmitted bit value having been transmitted.

FIGURE 6

EP 1 912 396 A2

**Description**

The present invention is in the field of wireless communication, and particularly, but not exclusively, the field of multiple input, multiple output (MIMO) communications systems.

Conventional communication systems can be represented mathematically as:

$$\mathbf{y} = \mathbf{Hx} + \mathbf{v}$$

in which, for a MIMO communication system, $\mathbf{y}$ is an $n$-by-1 vector representing the received signal, $\mathbf{H}$ is an n-by-m channel matrix modelling the transmission characteristics of the communications channel, $\mathbf{x}$ is an $m$-by-1 vector representing transmit symbols, $\mathbf{v}$ is an $n$-by-1 noise vector and wherein $m$ and $n$ denote the number-of transmit and receive antennas respectively.

It will be understood by the skilled reader that the same representation can be used for multi-user detection in CDMA systems.

Recent publications have demonstrated how the use of a technique called Lattice Reduction can improve the performance of MIMO detection methods.

For example, "Lattice-Reduction-Aided Detectors for MIMO Communication Systems", (H. Yao and G.W. Wornell, Proc. IEEE Globecom, Nov 2002, pp. 424-428) describes Lattice-reduction (LR) techniques for enhancing the performance of multiple-input multiple-output (MIMO) digital communication systems.

In addition, "Low-Complexity Near-Maximum-Likelihood Detection and Precoding for MIMO Systems using Lattice Reduction", (C. Windpassinger and R. Fischer, in Proc. IEEE Information Theory Workshop, Paris, March, 2003, pp. 346-348) studies the lattice-reduction-aided detection scheme proposed by Yao and Womell. It extends this with the use of the well-known LLL algorithm, which enables the application to MIMO systems with arbitrary numbers of dimensions.

"Lattice-Reduction-Aided Receivers for MIMO-OFDM in Spatial Multiplexing Systems", (I. Berenguer, J. Adeane, I. Wassell and X. Wang, in Proc. Int. Symp. on Personal Indoor and Mobile Radio Communications, Sept. 2004, pp. 1517-1521, hereinafter referred to as "Berenguer et al.") describes the use of Orthogonal Frequency Division Multiplexing (OFDM) to significantly reduce receiver complexity in wireless systems with Multipath propagation, and notes its proposed use in wireless broadband multi-antenna (MIMO) systems.

Finally, "MMSE-Based Lattice-Reduction for Near-ML Detection of MIMO Systems", (D. Wubben, R. Bohnke, V. Kuhn and K. Kammeyer, in Proc. ITG Workshop on Smart Antennas, 2004, hereinafter referred to as "Wubben et al.") adopts the lattice-reduction aided schemes described above to the MMSE criterion.

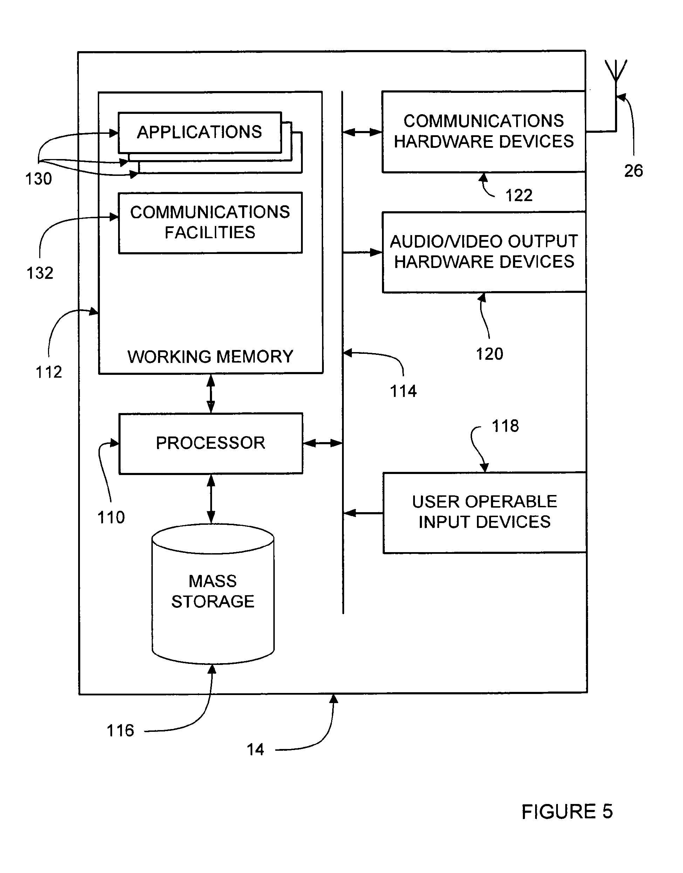

The techniques used in the publications described above use the concept that mathematically, the columns of the channel matrix, $\mathbf{H}$, can be viewed as describing the basis of a lattice. An equivalent description of this lattice (a so-called 'reduced basis') can therefore be calculated so that the basis vectors are close to orthogonal. If the receiver then uses this reduced basis to equalise the channel, noise enhancement can be kept to a minimum and detection performance will improve (such as, as illustrated in Figure 5 in Wubben et al.). This process comprises the steps described as follows:

$\mathbf{y}_r$, $\mathbf{x}_r$ and $\mathbf{H}_r$ are defined to be the real-valued representations of y, x, and H respectively, such that:

$$\mathbf{y}_r = \begin{bmatrix} \mathrm{Re}(\mathbf{y}) \\ \mathrm{Im}(\mathbf{y}) \end{bmatrix}, \qquad \mathbf{x}_r = \begin{bmatrix} \mathrm{Re}(\mathbf{x}) \\ \mathrm{Im}(\mathbf{x}) \end{bmatrix}, \qquad \mathbf{H}_r = \begin{bmatrix} \mathrm{Re}(\mathbf{H}) & -\mathrm{Im}(\mathbf{H}) \\ \mathrm{Im}(\mathbf{H}) & \mathrm{Re}(\mathbf{H}) \end{bmatrix}$$

where Re() and Im() denote the real and imaginary components of their arguments.

It will be noted that Berenguer et al. describes the equivalent method in the complex plane, though for the purpose of clarity the Real axis representation of the method is used herein.

A number of lattice reduction algorithms exist in the art. One suitable lattice reduction algorithm is the Lenstra-Lenstra-Lovasz (LLL) algorithm referred to above, which is disclosed in Wubben et al., and also in "Factoring Polynomials with Rational Coefficients", (A. Lenstra, H. Lenstra and L. Lovasz, Math Ann., Vol. 261, pp. 515-534, 1982, hereinafter referred to as "Lenstra et al."), and in "An Algorithmic Theory of Numbers, Graphs and Convexity", (L. Lovasz, Philadelpia, SIAM, 1980, hereinafter referred to as "Lovasz").

Any one of these can be used to calculate a transformation matrix, T, such that a reduced basis, $\tilde{\mathbf{H}}_r$, is given by

$$\tilde{\mathbf{H}}_r = \mathbf{H}_r \mathbf{T}$$

The matrix T contains only integer entries and its determinant is +/-1.

After lattice reduction, the system is re-expressed as:

$$\begin{aligned}
\mathbf{y}_r &= \mathbf{H}_r \mathbf{x}_r + \mathbf{v}_r \\
&= \mathbf{H}_r \mathbf{T}\mathbf{T}^{-1}\mathbf{x}_r + \mathbf{v}_r \\
&= \tilde{\mathbf{H}}_r \mathbf{T}^{-1}\mathbf{x}_r + \mathbf{v}_r \\
&= \tilde{\mathbf{H}}_r \mathbf{z}_r + \mathbf{v}_r
\end{aligned}$$

where $\mathbf{z}_r = \mathbf{T}^{-1}\mathbf{x}_r$. The received signal, $\mathbf{y}_r$, in this redefined system is then equalised to obtain an estimate of $\mathbf{z}_r$. This equalisation process then employs, for example, a linear ZF technique, which obtains:

$$\tilde{\mathbf{z}}_r = (\tilde{\mathbf{H}}_r^* \tilde{\mathbf{H}}_r)^{-1}\tilde{\mathbf{H}}_r^* \mathbf{y}_r$$

Since $\tilde{\mathbf{H}}_r$ is close to orthogonal, $\tilde{\mathbf{z}}_r$ should suffer much less noise enhancement than if the receiver directly equalised the channel $\mathbf{H}_r$.

Of course, other equalisation techniques could be used. For example, MMSE techniques, or more complex successive interference cancellation based methods, such as in the published prior art identified above, could be considered for use.

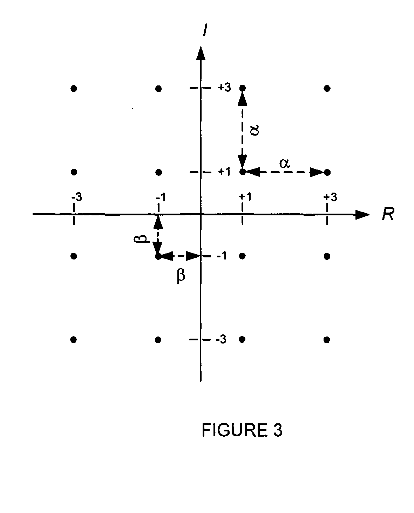

A receiver in accordance with the above operates in the knowledge that the transmitted symbols contained in **x** are obtained from an M-QAM constellation. With this constraint, $\mathbf{x_r}$ can be formed as $x_r = \alpha s + \beta$, where s is taken from the set of integers limited by the dimension of the lattice, and $\alpha$ and $\beta$ are scalar values obtained from the definition of the M-QAM constellation in use. $\alpha$ is equal to the minimum distance between two constellation points and $\beta$ is equal to the offset from the origin when s=0. In the present example, a 16-QAM constellation is used, having real and imaginary components of {+/-1, +/-3}. Therefore, as shown in figure 3, $\alpha$=2, and $\beta$=1.

$\tilde{\mathbf{z}}_r$ can then be quantised as $\hat{\mathbf{z}}_r$, in accordance with the method indicated in Wubben et al.:

$$\hat{\mathbf{z}}_r = \alpha Q\left\{\frac{1}{\alpha}\left(\tilde{\mathbf{z}}_r - \mathbf{T}^{-1}\mathbf{1}\beta\right)\right\} + \mathbf{T}^{-1}\mathbf{1}\beta$$

where Q{} is a quantisation function which rounds each element of its argument to the nearest integer, and where **1** is a column vector of ones.

It will be understood from the above that, the quantisation function apart, the remaining operations are a result of M-QAM constellations being scaled and translated versions of the integer lattice. The integer quantisation therefore requires the same simple scaling and translation operations.

Finally, the estimate $\hat{\mathbf{x}}_r$ of $\mathbf{x}_r$ is obtained by this method as

$$\hat{\mathbf{x}}_r = \mathbf{T}\hat{\mathbf{z}}_r$$

Occasionally, if errors are present in the estimate of $\hat{\mathbf{z}}_r$, then it is possible that some of the symbol estimates in $\hat{\mathbf{x}}_r$ may not be valid symbols. In such cases, these symbols are mapped to the nearest valid symbol. For example, for the present example employing 16-QAM, the values +/-1, +/-3 may define the valid entries in $\hat{\mathbf{x}}_r$. Therefore if a component of $\hat{\mathbf{x}}_r$ were, for example, equal to +5, then this would be mapped to a value of +3.

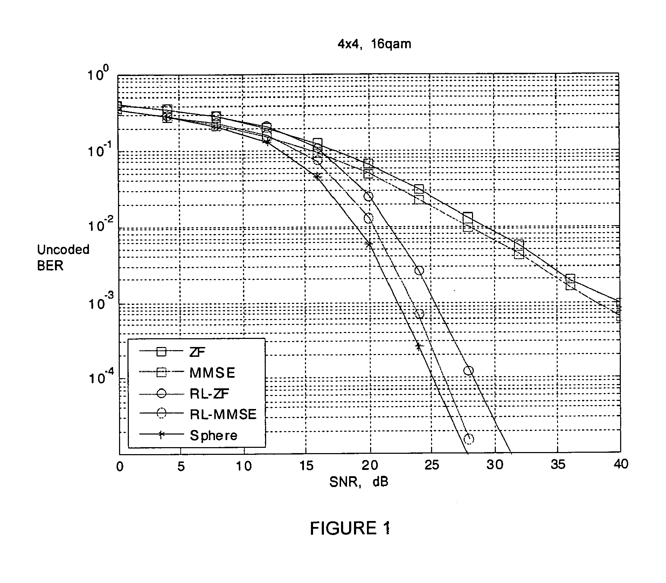

Figure 1 demonstrates the advantages of techniques in accordance with the published art, including the above described example thereof, over other MIMO detection methods for an uncoded system. 'ZF' and 'MMSE' refer to the standard linear detection methods, 'RL-ZF' and 'RL-MMSE' refer to the lattice reduction aided methods, and 'Sphere' refers to results obtained using the Sphere decoding algorithm (almost identical to the performance of maximum-likelihood detection).

Such reduced lattice detectors (e.g. for MIMO systems) usually output hard decisions. The only mention in the literature of a technique that could be employed for obtaining soft-output is "From Lattice-Reduction-Aided Detection Towards Maximum-Likelihood Detection in MIMO Systems", (C. Windpassinger, L. Lampe and R. Fischer, in Proc. Int. Conf. on Wireless and Optical Communications, Banff, Canada, July 2003, hereinafter referred to as "Windpassinger et al."). The method that Windpassinger et al. proposes is complex, and the performance of this technique was not validated in the publication.

US Patent 6724843 describes a detector in which received symbols are decoded in a multiple-antenna communication system using lattice-based decoding. The symbols are generated using a modulation constellation, e.g., a diagonal modulation constellation, and the constellation is characterized as a lattice for decoding purposes. For example, if a given communication link of the multiple-antenna communication system includes M transmitter antennas and a single receiver antenna, the diagonal modulation constellation can be characterized as a lattice in M dimensions. A differential decoding operation for received differential symbols involves a determination of the closest point in the lattice corresponding to the constellation. This determination may be made in an efficient manner using a basis reduction algorithm which generates an approximately orthogonal basis for the lattice, and then utilizes component-wise rounding to determine the closest point. The lattice-based decoding has a complexity which is polynomial rather than exponential in the particular number of antennas and the system rate, but is nonetheless able to deliver error rate performance which approximates that of maximum likelihood decoding.

Therefore, with the exception of Windpassinger et al., the reduced lattice detection schemes described in all other references only output hard decisions for the estimate of the transmitted symbol vector, $\hat{x}$. When used in a system with an outer channel code (i.e. in any practical system) the performance of the code can be substantially improved if it is supplied with soft-information, e.g. a log-likelihood ratio (LLR) for each bit.

UK patent application 0518036.9 (as yet unpublished) describes an approach which makes use of the above and further presents a method of obtaining soft estimates using candidate vectors in a reduced basis and selecting the most likely candidate on the basis of probabilities determined for the candidate vectors.

An aspect of the invention provides a method for determining soft estimates of transmitted bit values from a received signal in a lattice-reduction-aided receiver based wireless communications system, the method comprising obtaining an estimate of the channel response, applying lattice reduction to said channel response and equalising said received signal in accordance with the reduced basis channel, and determining probabilities of transmitted bits having particular values by means of selecting a set of candidate symbols by selecting a core candidate vector in the reduced basis, determining a set of mapping functions between vectors in the reduced basis and transmitted symbol vectors from which a set of candidate transmitted symbol vectors can be generated, generating the set of candidate transmitted signal vectors on the basis of the mapping functions and, on the basis of the received signal, determining the probability of each transmitted bit value estimate having been transmitted.

Preferably, the method provides applying lattice reduction in accordance with the LLL algorithm.

The method is suitable for use in a MIMO wireless communications system. Further, it can be used with any other system wherein a received signal is the result of transmission from a plurality of antennas, which may or may not be collocated. Further, the method is applicable to CDMA systems, such as multi-user detection (MUD).

Yet another aspect of the invention provides a receiver for use in a lattice-reduction-aided receiver based wireless communications system, the receiver comprising means for obtaining an estimate of the channel response and a detector operable to process a received signal so as to determine soft estimates of transmitted bit values, the detector comprising means for applying lattice reduction to the channel response estimate and equalising the received signal in accordance with the reduced basis channel, and soft information determining means for determining probabilities of transmitted bits having particular values, the soft information determining means comprising of means for selecting a core candidate symbol vector in the reduced basis, means for determining a set of mapping functions between vectors in the reduced basis and transmitted symbol vectors from which a set of candidate transmitted symbol vectors can be generated, means for generating a set of candidate transmitted signal vectors on the basis of said mapping functions and, means for determining the probability of said transmitted bit value having been transmitted, on the basis of the received signal.

Another aim of the present invention is to provide a method for obtaining log-likelihood ratios (LLRs) for bits at the output of a lattice-reduction-aided MIMO receiver.

To this end, the probabilities determined in either the method above or by the detector above can be converted into LLRs.

The reader will appreciate that aspects of the invention can also be embodied by means of computer implemented means, for instance under the direction of a suitable software product. Such a software product can be in the form of a storage medium, for instance a computer readable optical or magnetic disk, or by way of a signal borne on a computer receivable carrier.

Figure 1 illustrates a graph of performance of prior art examples described above in comparison with standard MIMO detection methods for an uncoded system;

Figure 2 illustrates a graph of performance of prior art examples described above in comparison with standard MIMO detection methods for a coded system;

Figure 3 illustrates a graph of a lattice used in the wireless communications system of a specific embodiment of the invention, and used in the described examples of the prior art;

Figure 4 illustrates schematically a MIMO system including a transmitter and a receiver;

Figure 5 illustrates in further detail the receiver of figure 4;

Figure 6 illustrates a detecting method operable by means of the detector illustrated in figure 5.

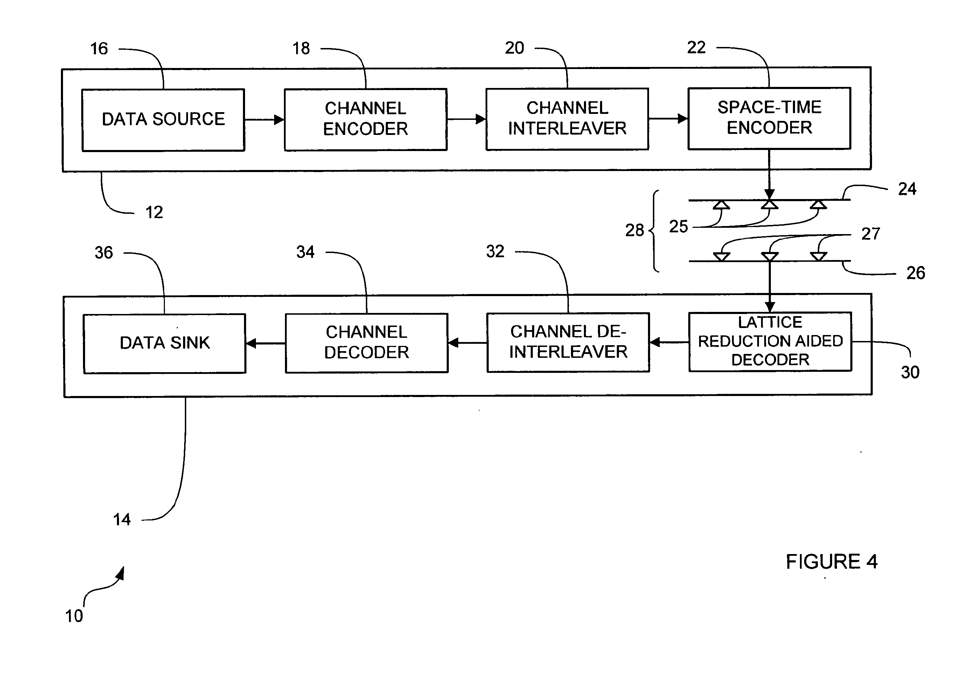

The present invention will now be described with reference to an implementation thereof for the equalization of a wireless communication system. Figure 4 illustrates such a system, comprising a MIMO data communications system 10 of generally known construction. New components, in accordance with a specific embodiment of the invention, will be evident from the following description.

The communications system 10 comprises a transmitter device 12 and a receiver device 14. It will be appreciated that, in many circumstances, a wireless communications device will be provided with the facilities of a transmitter and a receiver in combination but, for this example, the devices have been illustrated as one way communications devices for reasons of simplicity.

The transmitter device 12 comprises a data source 16, which provides data (comprising information bits or symbols) to a channel encoder 18. The channel encoder 18 is followed by a channel interleaver 20 and, in the illustrated example, a space-time encoder 22. The space-time encoder 22 encodes an incoming symbol or symbols as a plurality of code symbols for simultaneous transmission from a transmitter antenna array 24 comprising a plurality of transmit antennas 25. In this illustrated example, three transmit antennas 25 are provided, though practical implementations may include more, or fewer antennas depending on the application.

The encoded transmitted signals propagate through a MIMO channel 28 defined between the transmit antenna array 24 and a corresponding receive antenna array 26 of the receiver device 14. The receive antenna array 26 comprises a plurality of receive antennas 27 which provide a plurality of inputs to a lattice-reduction-aided decoder 30 of the receiver device 14. In this specific embodiment, the receive antenna array 26 comprises three receive antennas 27 although, again, this number is not essential for performance of the invention.

The lattice-reduction-aided decoder 30 has the task of removing the effect of the MIMO channel 28. The output of the lattice-reduction-aided decoder 30 comprises a plurality of signal streams, one for each transmit antenna 25, each carrying so-called soft or likelihood data on the probability of a transmitted bit having a particular value. This data is provided to a channel de-interleaver 32 which reverses the effect of the channel interleaver 20, and the de-interleaved bits output by this channel de-interleaver 32 are then presented to a channel decoder 34, in this example a Viterbi decoder, which decodes the convolutional code. The output of channel decoder 34 is provided to a data sink 36, for further processing of the data in any desired manner.

The specific function of the lattice-reduction-aided decoder 30 will be described in due course.

Figure 5 illustrates, schematically, hardware operably configured (by means of software or application specific hardware components) as the receiver device 16. The receiver device 16 comprises a processor 110 operable to execute machine code instructions stored in a working memory 112 and/or retrievable from a mass storage device 116. By means of a general purpose bus 114, user operable input devices 118 are capable of communication with the processor 110. The user operable input devices 118 comprise, in this example, a keyboard and a mouse though it will be appreciated that any other input devices could also or alternatively be provided, such as another type of pointing device, a writing tablet, speech recognition means, or any other means by which a user input action can be interpreted and converted into data signals.

Audio/video output hardware devices 120 are further connected to the general purpose bus 114, for the output of information to a user. Audio/video output hardware devices 120 can include a visual display unit, a speaker or any other device capable of presenting information to a user.

Communications hardware devices 122, connected to the general purpose bus 114, are connected to the antenna 26. In the illustrated embodiment in Figure 5, the working memory 112 stores user applications 130 which, when executed by the processor 110, cause the establishment of a user interface to enable communication of data to and from a user. The applications in this embodiment establish general purpose or specific computer implemented utilities that might habitually be used by a user.

Communications facilities 132 in accordance with the specific embodiment are also stored in the working memory 112, for establishing a communications protocol to enable data generated in the execution of one of the applications 130 to be processed and then passed to the communications hardware devices 122 for transmission and communication with another communications device. It will be understood that the software defining the applications 130 and the communications facilities 132 may be partly stored in the working memory 112 and the mass storage device 116, for convenience. A memory manager could optionally be provided to enable this to be managed effectively, to take account of the possible different speeds of access to data stored in the working memory 112 and the mass storage device 116.

On execution by the processor 110 of processor executable instructions corresponding with the communications facilities 132, the processor 110 is operable to establish communication with another device in accordance with a recognised communications protocol.

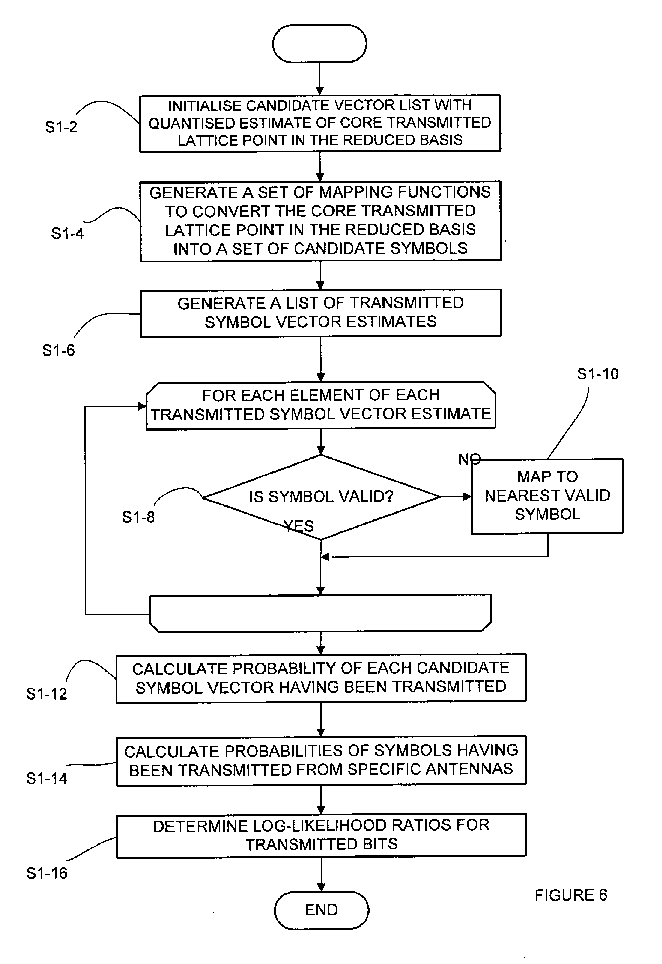

The function of the lattice-reduction aided decoder 30 will now be described in further detail in accordance with figure 6. This method as illustrated commences once the quantised estimate of the transmitted lattice point in the reduced basis, i.e. $\hat{\mathbf{z}}_r$, has been determined as outlined in the introduction and discussion of the prior art above. The manner in which this estimate is obtained is immaterial: any appropriate lattice reduction algorithm may have been used, and any of a number of equalisation methods may have been applied.

In step S1-2, the vector $\hat{\mathbf{z}}_r$ is taken as the core candidate vector. In step S1-4 a set of mapping functions is generated. Each mapping function is a means for the generation of another candidate transmitted symbol vector from the core transmitted symbol vector. The manner in which this is achieved, in accordance with the present embodiment, will now be described.

Expressed in the reduced basis, the additional list of candidate vectors to be considered as a transmitted symbol vector consists of all vectors that vary from the core candidate vector by modification of one or more elements of the vector $\hat{\mathbf{z}}_r$. Whilst any of these additional candidate vectors may differ from $\hat{\mathbf{z}}_r$ in more than one element, the example described herein generates candidates by only allowing these to vary one element of $\hat{\mathbf{z}}_r$. Creating candidate vectors by allowing perturbations to multiple elements of $\hat{\mathbf{z}}_r$ can slightly improve performance, but at the expense of increasing the length of the candidate list and hence increasing complexity.

For subsequent use in the decoder, candidate vectors need to be expressed in terms of the original lattice basis. To do this, the above mentioned candidate vectors would need to be converted from the reduced basis into the original basis. Such conversions require the use of matrix calculations, and this action would consume considerable computational resources.

By generating a set of mapping functions between the core candidate and additional candidates, it is only necessary to carry out the above conversion on the core candidate. Mapping functions that do not require full matrix calculations can be created, and so such functions will require less computation than would otherwise be possible.

In the present embodiment, $\hat{\mathbf{x}}_r$ is a 2-by-1 vector, so the set of 5 candidate vectors, $\mathbf{c}^{(i)}$, expressed in the reduced lattice, are as follows:

$$\mathbf{c}^{(1)} = \begin{bmatrix} \hat{z}_{r1} \\ \hat{z}_{r2} \end{bmatrix} \qquad \mathbf{c}^{(2)} = \begin{bmatrix} \hat{z}_{r1} + \alpha \\ \hat{z}_{r2} \end{bmatrix} \qquad \mathbf{c}^{(3)} = \begin{bmatrix} \hat{z}_{r1} - \alpha \\ \hat{z}_{r2} \end{bmatrix}$$

$$\mathbf{c}^{(4)} = \begin{bmatrix} \hat{z}_{r1} \\ \hat{z}_{r2} + \alpha \end{bmatrix} \qquad \mathbf{c}^{(5)} = \begin{bmatrix} \hat{z}_{r1} \\ \hat{z}_{r2} - \alpha \end{bmatrix}$$

In the original lattice, these candidate vectors are expressed as:

$$\hat{\mathbf{x}}_r^{(1)} = \mathbf{T}\mathbf{c}^{(1)} \qquad \hat{\mathbf{x}}_r^{(2)} = \mathbf{T}\mathbf{c}^{(2)} \qquad \hat{\mathbf{x}}_r^{(3)} = \mathbf{T}\mathbf{c}^{(3)}$$

$$\hat{\mathbf{x}}_r^{(4)} = \mathbf{T}\mathbf{c}^{(4)} \qquad\qquad \hat{\mathbf{x}}_r^{(5)} = \mathbf{T}\mathbf{c}^{(5)}$$

$\hat{\mathbf{x}}_r^{(2)}$ for example, can be expressed as:

$$\hat{\mathbf{x}}_r^{(2)} = \mathbf{T}\mathbf{c}^{(2)}$$

$$= \mathbf{T}\left( \mathbf{c}^{(1)} + \begin{bmatrix} \alpha \\ 0 \end{bmatrix} \right)$$

$$= \mathbf{T}\mathbf{c}^{(1)} + \mathbf{T}\begin{bmatrix} \alpha \\ 0 \end{bmatrix}$$

$$= \hat{\mathbf{x}}_r^{(1)} + \alpha\mathbf{T}_{(:,1)}$$

Hence by the same method,

$$\hat{\mathbf{x}}_r^{(3)} = \hat{\mathbf{x}}_r^{(1)} - \alpha\mathbf{T}_{(:,1)}$$

$$\hat{\mathbf{x}}_r^{(4)} = \hat{\mathbf{x}}_r^{(1)} + \alpha\mathbf{T}_{(:,2)}$$

$$\hat{\mathbf{x}}_r^{(5)} = \hat{\mathbf{x}}_r^{(1)} - \alpha\mathbf{T}_{(:,2)}$$

where $\mathbf{T}_{(:,i)}$ represents the $i^{\text{th}}$ column of matrix T.

Thus it is only necessary to perform the full matrix multiplication once, calculating for example $\hat{\mathbf{x}}_r^{(1)}$, in order to generate the full set of candidate transmitted symbol vectors.

Although in the present embodiment, $\hat{\mathbf{x}}_r$ is a 2-by-1 vector, it will be appreciated that a similar approach could be taken in other embodiments of the invention wherin vectors of different dimension are used.

It will be appreciated that other methods of generating suitable candidates are possible, and would provide a suitable list for further processing in accordance with the method. One alternative method would be to perturb not just one element at a time, but to perturb two simultaneously. Therefore, for each pair of elements, the decoder would cycle through the four combinations of perturbing by +/- $\alpha$. Then, the decoder would pick the next pair of elements and repeat in order to generate more candidates.

Candidate transmitted symbol vectors are then obtained in step S1-6 by applying the mapping functions calculated in step S1-4 to the core candidate transmitted symbol vector.

Just as for the hard-output detector outlined in the introduction and discussion of the prior art above, it is possible that some of the elements of the vector $\hat{\mathbf{x}}_r^{(i)}$ may not be valid symbols. Therefore, step S1-8 seeks to determine if this is the case, and, if so, in step S1-10, these symbols are mapped to the nearest valid symbol. (e.g. for 16-QAM, if the values +/-1, +/-3 define the valid entries as illustrated in figure 3, then if an element were for example equal to +5, this would be mapped to a value of +3.)

For each candidate symbol vector $\hat{\mathbf{x}}_r^{(i)}$ (corrected, if required), in step S1-12, the detector calculates its probability of being transmitted, as:

$$p^{(i)} = \frac{1}{\sqrt{\pi \sigma_v^2}} \exp\left(\frac{-\left\|\mathbf{y}_r - \mathbf{H}_r \hat{\mathbf{x}}_r^{(i)}\right\|}{\sigma_v^2}\right)$$

These probabilities are then used to calculate, in step S1-14, the probability of symbol *x'* having been transmitted from antenna k, where $x' \in X$ and X defines the set of symbols in the chosen constellation.

$$P(k, x') = \sum_{\{i | \hat{x}_k^{(i)} = x'\}} p^{(i)} \qquad \text{for } k = 1, \ldots, m \quad \text{and} \quad x' \in X$$

Depending on the list of candidates, according to the above definition P may not be specified for all values of k and *x'*. In these cases P is set to a default (small) value. This default can be a fixed value or it could varied according to a method such as that described in "Adaptive Selection of Surviving Symbol Replica Candidates Based on Maximum Reliability in QRM-MLD for OFCDM MIMO Multiplexing" (K. Higuchi, H. Kawai, N. Maeda and M. Sawahashi, in Proc. IEEE Globecom, Dallas, Dec. 2004), or by any other appropriate method.

Now that the receiver has information on the probability of different symbols having been transmitted, these are processed in a conventional manner in step S1-16 to obtain a log-likelihood ratio for each transmitted bit. In the present example, this is done as follows:

$$L(b_{k,i}) = \log\left(\frac{\sum_{x' \in X^{(1)}} P(k, x')}{\sum_{x'' \in X^{(0)}} P(k, x'')}\right)$$

where $L(b_{k,i})$ is the log-likelihood ratio of bit $b_{k,i}$, k indicates the transmit antenna, i=1,...,M where M is the number of bits per symbol, and where X(1) and X(0) are the sets of symbols for which $b_{k,i} = 1$ and $b_{k,i} = 0$ respectively.

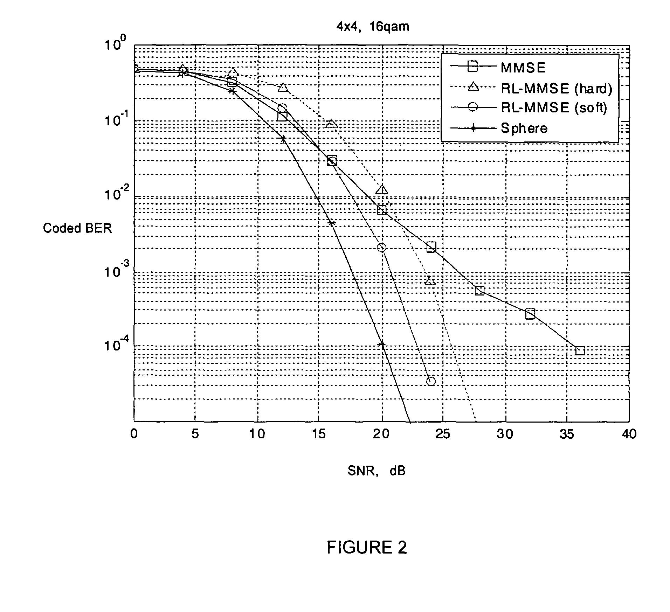

The graph of figure 2 sets out experimental performance data using a method in accordance with the above described embodiment in comparison with prior art decoding methods aiming to provide hard information for the channel decoder. Figure 2 demonstrates the benefit that can be obtained by providing a lattice reduction detection scheme to output soft information for the channel decoder.

It will be appreciated that the foregoing disclosure of specific embodiments of the invention can be applied to any communications product employing MIMO transmission techniques, to take advantage of the benefits of the invention. Further, the invention is applicable to any circumstance in which the detection of symbols, which may be based on multiple input, is required. This could arise in systems where a plurality of antennas are provided in separate locations. Further, CDMA MUD may be a suitable basis for use of the method of the present invention.

The invention has been described by way of a software implementation. This software implementation can be introduced as a stand alone software product, such as borne on a storage medium, e.g. an optical disk, or by means of a signal. Further, the implementation could be by means of an upgrade or plug-in to existing software, or by introduction of solid state memory means storing the relevant executable instructions.

Whereas the invention can be so provided, it could also be by way exclusively by hardware, such as on an ASIC.

The reader will appreciate that the foregoing is but one example of implementation of the present invention, and that further aspects, features, variations and advantages may arise from using the invention in different embodiments. The scope of protection is intended to be provided by the claims appended hereto, which are to be interpreted in the light of the description with reference to the drawings and not to be limited thereby.

**Claims**

1.  A method for determining soft estimates of transmitted bit values from a received signal in a lattice-reduction-aided receiver based wireless communications system, the method comprising obtaining an estimate of the channel response, applying lattice reduction to said channel response and equalisation of said received signal in accordance with the reduced basis channel, and determining probabilities of transmitted bits having particular values by means of selecting a set of candidate symbols by selecting a core candidate vector in the reduced basis, determining a set of mapping functions between vectors in the reduced basis and transmitted symbol vectors from which a set of additional candidate transmitted symbol vectors can be generated, generating the set of additional candidate transmitted signal vectors on the basis of said mapping functions, and determining the probability of each transmitted bit value having been transmitted.

2.  A method in accordance with claim 1 whereby said additional candidate symbol vectors in the reduced basis are separated from the core candidate symbol vector by a distance equal to the minimum separation, or multiple thereof, between constellation points in the said reduced lattice, and separated in any one direction that is parallel to a reduced lattice basis vector.

3.  A method in accordance with claim 1 whereby said additional candidate symbol vectors in the reduced basis are separated from the core candidate symbol vector by perturbation, by a distance equal to the minimum separation, or multiple thereof, between constellation points in the said reduced lattice, in more than one direction along reduced lattice basis vectors.

4.  A method in accordance with any preceding claim whereby the said lattice reduction is implemented by a process that involves the determination of a suitable lattice transformation matrix.

5.  A method in accordance with claim 4 whereby the said mapping functions are determined by selection of only appropriate sections of the said transformation matrix, and combination of the said appropriate sections with predetermined mapping equations, thereby avoiding the need for comprehensive matrix calculations.

6.  A method in accordance with any preceding claim and further including the step of mapping said list of candidate transmitted symbol vectors to permitted transmitted symbols.

7.  A method in accordance with any preceding claim wherein the step of determining transmitted bit probabilities includes determining the probability of each candidate symbol vector having been transmitted and then determining the probabilities of all possible symbols having been transmitted from each of said transmitter antennas.

8.  A method in accordance with claim 7 and further comprising the step of determining Log Likelihood Ratios (LLRs) from the determined probabilities.

9.  A method in accordance with any preceding claim and wherein the lattice reduction is in accordance with the LLL algorithm.

10. A method in accordance with any preceding claim used in a MIMO communications system.

11. Apparatus for determining soft estimates of transmitted bit values from a received signal in a lattice-reduction-aided receiver based wireless communications system, comprising means for obtaining an estimate of the channel response, means for applying lattice reduction to said channel response, means for equalisation of the received signal in accordance with the reduced basis channel, and soft information determining means for determining probabilities of transmitted bits having particular values, said soft information determining means comprising means for selecting a core candidate symbol vector in the reduced basis, means for determining a set of mapping functions between vectors in the reduced basis and transmitted symbol vectors, means for generating a set of additional candidate transmitted signal vectors on the basis of said mapping functions and, means for determining the probability of said transmitted bit value having been transmitted, on the basis of the received signal.

12. Apparatus in accordance with claim 11 including symbol validation means for mapping said list of candidate transmitted symbol vectors to permitted transmitted symbol vectors.

13. Apparatus in accordance with claim 11 or claim 12 wherein said soft information determining means is operable to determine the probability of said symbol vector having been transmitted and then to determine the probabilities of all possible symbols having been transmitted from each of said transmitter antennas.

14. A MIMO wireless communications apparatus including a detector comprising apparatus in accordance with any one of claims 11 to 13.

15. A computer program product comprising computer executable instructions which, when executed on general purpose computer controlled communications apparatus, cause the apparatus to become configured to perform the method of any of claims 1 to 10.

16. A storage medium storing computer executable instructions which, when executed on general purpose computer controlled communications apparatus, cause the apparatus to become configured to perform the method of any of claims 1 to 10.

17. A signal carrying computer receivable information, the information defining computer executable instructions which, when executed on general purpose computer controlled communications apparatus, cause the apparatus to become configured to perform the method of any of claims 1 to 10.

4x4, 16qam

FIGURE 1

FIGURE 2

FIGURE 3

FIGURE 4

EP 1 912 396 A2

FIGURE 5

S1-2 — INITIALISE CANDIDATE VECTOR LIST WITH QUANTISED ESTIMATE OF CORE TRANSMITTED LATTICE POINT IN THE REDUCED BASIS

S1-4 — GENERATE A SET OF MAPPING FUNCTIONS TO CONVERT THE CORE TRANSMITTED LATTICE POINT IN THE REDUCED BASIS INTO A SET OF CANDIDATE SYMBOLS

S1-6 — GENERATE A LIST OF TRANSMITTED SYMBOL VECTOR ESTIMATES

FOR EACH ELEMENT OF EACH TRANSMITTED SYMBOL VECTOR ESTIMATE

S1-8 — IS SYMBOL VALID?

NO

S1-10 — MAP TO NEAREST VALID SYMBOL

YES

S1-12 — CALCULATE PROBABILITY OF EACH CANDIDATE SYMBOL VECTOR HAVING BEEN TRANSMITTED

S1-14 — CALCULATE PROBABILITIES OF SYMBOLS HAVING BEEN TRANSMITTED FROM SPECIFIC ANTENNAS

S1-16 — DETERMINE LOG-LIKELIHOOD RATIOS FOR TRANSMITTED BITS

END

FIGURE 6

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 6724843 B
- GB 0518036 A

**Non-patent literature cited in the description**

- **H. YAO ; G.W. WORNELL.** Lattice-Reduction-Aided Detectors for MIMO Communication Systems. *Proc. IEEE Globecom,* November 2002, 424-428
- **C. WINDPASSINGER ; R. FISCHER.** Low-Complexity Near-Maximum-Likelihood Detection and Precoding for MIMO Systems using Lattice Reduction. *Proc. IEEE Information Theory Workshop,* March 2003, 346-348
- **I. BERENGUER ; J. ADEANE ; I. WASSELL ; X. WANG.** Lattice-Reduction-Aided Receivers for MIMO-OFDM in Spatial Multiplexing Systems. *Proc. Int. Symp. on Personal Indoor and Mobile Radio Communications,* September 2004, 1517-1521
- **D. WUBBEN ; R. BOHNKE ; V. KUHN ; K. KAMMEYER.** MMSE-Based Lattice-Reduction for Near-ML Detection of MIMO Systems. *Proc. ITG Workshop on Smart Antennas,* 2004
- **A. LENSTRA ; H. LENSTRA ; L. LOVASZ.** Factoring Polynomials with Rational Coefficients. *Math Ann,* 1982, vol. 261, 515-534
- **L. LOVASZ.** An Algorithmic Theory of Numbers, Graphs and Convexity. *SIAM,* 1980
- **C. WINDPASSINGER ; L. LAMPE ; R. FISCHER.** From Lattice-Reduction-Aided Detection Towards Maximum-Likelihood Detection in MIMO Systems. *Proc. Int. Conf. on Wireless and Optical Communications,* July 2003
- **K. HIGUCHI ; H. KAWAI ; N. MAEDA ; M. SAWAHASHI.** Adaptive Selection of Surviving Symbol Replica Candidates Based on Maximum Reliability in QRM-MLD for OFCDM MIMO Multiplexing. *Proc. IEEE Globecom,* December 2004